# EUROPÄISCHE PATENTSCHRIFT

(11) **EP 2 697 835 B1**
(45) Veröffentlichungstag und Bekanntmachung des Hinweises auf die Patenterteilung: **04.09.2019**
(21) Anmeldenummer: 12713140.7
(22) Anmeldetag: 04.04.2012
(51) Int. Cl.: H01L 33/00, H01S 5/02, H01L 21/78

(54) **VERFAHREN ZUR HERSTELLUNG EINES HALBLEITERKÖRPERS**
METHOD FOR PRODUCING A SEMICONDUCTOR BODY
PROCÉDÉ POUR LA FABRICATION D'UN CORPS SEMI-CONDUCTEUR

(30) Priorität: 14.04.2011 DE 102011017097
(43) Veröffentlichungstag der Anmeldung: 19.02.2014
(73) Patentinhaber: OSRAM Opto Semiconductors GmbH, 93055 Regensburg (DE)
(72) Erfinder: PERZLMAIER, Korbinian, 93051 Regensburg (DE); ZULL, Heribert, 93049 Regensburg (DE); EBERHARD, Franz, 93059 Regensburg (DE); VEIT, Thomas, 93098 Mintraching (DE); KÄMPF, Mathias, 93133 Burglengenfeld (DE); DENNEMARCK, Jens, 93055 Regensburg (DE)
(74) Vertreter: Epping - Hermann - Fischer
(86) Internationale Anmeldenummer: PCT/EP2012/056183
(87) Internationale Veröffentlichungsnummer: WO 2012/139953

(56) Entgegenhaltungen:
- EP-A1- 2 216 833
- EP-A2- 1 592 070
- EP-A2- 2 197 051
- JP-A- S5 486 265
- JP-A- S53 105 964
- JP-B2- 3 636 835
- US-A1- 2010 264 442

## Beschreibung

Es wird ein Verfahren zur Herstellung eines Halbleiterkörpers angegeben.

Ein Verfahren zur Herstellung eines Halbleiterkörpers ist beispielsweise in der Druckschrift EP 1 592 070 A2 beschrieben. In der Druckschrift EP 2 197 051 A2 und in der Druckschrift US 2010/264442 A1 ist jeweils ein Verfahren zur Herstellung eines lichtemittierenden Bauteils beschrieben. Die Druckschrift JP 3 636835 B2 beschreibt ein Verfahren zum Trennen von Substraten, die Druckschrift JP S54 86265 A beschreibt ein Verfahren zur Herstellung eines Halbleiterbauteils und die Druckschrift JP S53 105964 A beschreibt ebenfalls ein Verfahren zur Herstellung eines Halbleiterbauteils.

Eine Aufgabe der Erfindung ist es, ein Verfahren zur Herstellung eines Halbleiterkörpers anzugeben, bei dem die zu erzeugenden Halbleiterkörper während des Vereinzelns nur einer geringen Gefahr der Schädigungen ausgesetzt sind.

Diese Aufgabe wird durch ein Verfahren mit den Schritten des Patentanspruchs 1 gelöst. Vorteilhafte Ausführungsformen und Weiterbildungen des Verfahrens sind in den abhängigen Ansprüchen angegeben.

Ein Verfahren zur Herstellung eines Halbleiterkörpers umfasst die folgenden Schritte:
- Bereitstellen eines Halbleiterwafers mit mindestens zwei Chipbereichen und mindestens einem Trennbereich, der zwischen den Chipbereichen angeordnet ist, wobei der Halbleiterwafer eine Schichtenfolge aufweist, deren äußerste Schicht zumindest innerhalb des Trennbereiches eine transmittierende Schicht aufweist, die für elektromagnetische Strahlung durchlässig ist,
- Entfernen der transmittierenden Schicht innerhalb des Trennbereichs,
- Trennen der Chipbereiche entlang der Trennbereiche mittels eines Lasers.

Dieses Verfahren bietet den Vorteil, dass Schädigungen der äußersten transmittierenden Schicht der Schichtenfolge beim Lasertrennen zumindest vermindert werden können. Weist der Trennbereich als äußerste Schicht eine transmittierende Schicht auf, so wird die elektromagnetische Strahlung des Lasers nur geringfügig innerhalb der transmittierenden Schicht absorbiert, so dass die transmittierende Schicht selber nur eine geringfügige Trennwirkung durch den Laser erfährt. Das unter der transmittierenden Schicht liegende Material absorbiert hingegen die Strahlung des Lasers in der Regel deutlich stärker, so dass dieses verdampft und die transmittierende Schicht zumindest im Trennbereich lokal absprengt. Auf diese Art und Weise kann es zu Rissen in der transmittierenden Schicht kommen. Weiterhin kann Schlacke, die beim Trennprozess entsteht, auf die Chipbereiche gelangen, wo sie nur schwer zu entfernen ist.

Bei dem zu erzeugenden Halbleiterkörper kann es sich beispielsweise um einen optoelektronischen Halbleiterkörper handeln.

Bei dem Trennbereich kann es sich beispielsweise um einen Sägegraben handeln.

Gemäß einer Ausführungsform weist die Schichtenfolge des optoelektronischen Halbleiterkörpers innerhalb eines Chipbereichs eine aktive Zone auf, die im Betrieb des Halbleiterkörpers elektromagnetische Strahlung erzeugt. Der Trennbereich durchdringt die aktive Zone hierbei besonders bevorzugt vollständig.

Die aktive Zone umfasst beispielsweise einen pn-Übergang, eine Doppelheterostruktur, einen Einfach-Quantentopf oder eine Mehrfach-Quantentopfstruktur (MQW) zur Strahlungserzeugung. Die Bezeichnung Quantentopfstruktur beinhaltet hierbei keine Angabe über die Dimensionalität der Quantisierung. Sie umfasst somit unter anderem Quantentröge, Quantendrähte und Quantenpunkte und jede Kombination dieser Strukturen.

Insbesondere optoelektronische Halbleiterkörper weisen, beispielsweise zum Schutz der aktiven Zone, eine Passivierungsschicht als äußerste Schicht ihrer Schichtenfolge auf, die als transmittierende Schicht ausgebildet ist. Die Passivierungsschicht ist beispielsweise vergleichsweise träge gegenüber chemischen Reaktionen etwa mit dem umgebenden Medium, wie Luft. Weiterhin kann die Passivierungsschicht auch elektrisch isolierend ausgebildet sein.

Die transmittierende Schicht weist besonders bevorzugt einen Transmissionskoeffizienten größer oder gleich 0,9 zumindest für Strahlung der aktiven Zone und/oder dem von dem optoelektronischen Halbleiterkörper ausgesandten Licht, in der Regel sichtbares Licht, auf.

Die transmittierende Schicht kann beispielsweise eines der folgenden Materialien enthalten oder aus einem der folgenden Materialien gebildet sein: Oxide, Nitride.

Die Dicke der transmittierenden Schicht liegt bevorzugt zwischen einschließlich 3 nm und einschließlich 500 nm.

Gemäß einer Ausführungsform des Verfahrens bedeckt die transmittierende Schicht die Seitenflächen der Chipbereiche zumindest im Bereich der aktiven Zone. Besonders bevorzugt bedeckt die transmittierende Schicht die Seitenflächen der Chipbereiche vollständig. Hierdurch kann vorteilhafterweise die aktive Zone geschützt werden. Eine elektrisch isolierende transmittierende Schicht schützt die aktive Zone in der Regel auch gegen Kurzschlüsse.

Die transmittierende Schicht wird innerhalb des Trennbereichs mit einem Ätzprozess entfernt. Bei dem Ätzprozess kann es sich beispielsweise um trockenchemisches oder nasschemisches Ätzen handeln.

Gemäß einer Ausführungsform des Verfahrens wird die transmittierende Schicht in dem Trennbereich und in den Chipbereichen lokal entfernt, so dass jeweils zumindest eine Öffnung in der transmittierenden Schicht innerhalb des Trennbereichs und innerhalb der Chipbereiche entsteht. Gemäß einer Ausführungsform des Verfahrens wird genau eine Öffnung in der transmittierenden Schicht innerhalb jedes Chipbereichs und genau eine Öffnung in der transmittierenden Schicht innerhalb des Trennbereichs erzeugt. Weiterhin wird vor dem Trennen der Chipbereiche eine metallische Schicht in den Öffnungen der transmittierenden Schicht angeordnet.

Die metallische Schicht innerhalb der Öffnung auf dem Chipbereich ist hierbei bevorzugt zur elektrischen Kontaktierung des jeweiligen Halbleiterkörpers und - falls vorhanden - der aktiven Zone vorgesehen. Durch Aufbringung der metallischen Schicht innerhalb der Öffnungen des Trennbereiches kann vorteilhafterweise die Absorption von Laserlicht innerhalb des Trennbereiches in der Regel erhöht werden. Weiterhin wird auf diese Art und Weise mit Vorteil ein zusätzlicher photolithographischer Schritt bei der Herstellung des Halbleiterkörpers in der Regel vermieden.

Die metallische Schicht kann aus verschiedenen Einzelschichten aufgebaut sein, wobei zumindest eine Einzelschicht ein Metall aufweist oder aus einem Metall besteht. Besonders bevorzugt weisen alle Einzelschichten ein Metall auf oder bestehen aus einem Metall. Beispielsweise können die Einzelschichten aus einem der folgenden Materialien bestehen oder eines der folgenden Materialien aufweisen: Titan, Platin, Gold.

Bevorzugt weist die metallische Schicht eine Dicke zwischen einschließlich 3 nm und einschließlich 5 µm auf.

Wird eine absorbierende Schicht auf der transmittierenden Schicht angeordnet, so weist diese bevorzugt eines der folgenden Materialien auf oder besteht aus einem der folgenden Materialien: Platin, Ruthenium, Rhodium, Osmium, Iridium, Zirkonium, Vanadium, Tantal, Chrom, Molybdän, Wolfram, Carbide, Wolframcarbid, Titancarbid, Siliziumcarbid, Silizium, Nitride, Titannitrid, Tantalnitrid.

Bevorzugt weist die absorbierende Schicht eine Dicke zwischen einschließlich 3 nm und einschließlich 5 µm auf.

Besonders bevorzugt wird die absorbierende Schicht in direktem Kontakt mit der transmittierenden Schicht angeordnet, so dass die transmittierende Schicht und die absorbierende Schicht eine gemeinsame Grenzfläche aufweisen.

Die absorbierende Schicht weist eine Schmelz- und/oder Siedetemperatur auf, die höher ist als die Schmelz- und/oder Siedetemperatur der transmittierenden Schicht. Auf diese Art und Weise kann bevorzugt während des Lasertrennprozesses die unter der absorbierenden Schicht liegende transmittierende Schicht zumindest teilweise mit aufgeschmolzen werden.

Besonders bevorzugt weist die absorbierende Schicht eine Schmelztemperatur von mindestens 1800 °C und/oder eine Siedetemperatur von mindestens 1800 °C auf.

Bevorzugt wird die absorbierende Schicht lediglich innerhalb des Trennbereichs lokal aufgebracht, während die Chipbereiche frei von der absorbierenden Schicht bleiben.

Eine lokale Erhöhung des Absorptionskoeffizienten der transmittierenden Schicht innerhalb des Trennbereichs kann beispielsweise mittels einer der folgenden Verfahren erzielt werden: Einbringen von Streuzentren in die transmittierende Schicht, Implantieren von Dotierstoffen in die transmittierende Schicht, nasschemische Modifikation. Auch eine lokale Erhöhung des Absorptionskoeffizienten der transmittierenden Schicht selber wird bevorzugt lediglich lokal innerhalb des Trennbereichs durchgeführt, während die transmittierende Schicht innerhalb des Chipbereichs unverändert bleibt.

Mit dem Verfahren kann beispielsweise ein optoelektronischer Dünnfilm-Halbleiterkörper, etwa ein Leuchtdiodenhalbleiterkörper in Dünnfilmbauweise, hergestellt werden. Hierbei weist jeder Chipbereich zumindest einen Dünnfilm-Halbleiterkörper auf oder wird aus einem Dünnfilm-Halbleiterkörper gebildet.

Ein optoelektronischer Dünnfilm-Halbleiterkörper zeichnet sich insbesondere durch eine epitaktische gewachsene Halbleiterschichtenfolge aus, die die zur Strahlungserzeugung oder Strahlungsdetektion geeignete aktive Zone umfasst, wobei ein Aufwachssubstrat der epitaktischen Halbleiterschichtenfolge entfernt oder derart gedünnt wurde, dass es die epitaktische Halbleiterschichtenfolge alleine nicht ausreichend mechanisch stabilisiert.

Zur mechanischen Stabilisierung wird auf der dem Aufwachssubstrat gegenüberliegenden Hauptfläche der epitaktischen Halbleiterschichtenfolge ein Träger angeordnet. Der Träger weist in der Regel ein Material auf, das von dem Wachstumssubstrat der Halbleiterschichtenfolge verschieden ist. Der Träger kann beispielsweise eines der folgenden Materialien aufweisen oder aus einem der folgenden Materialien bestehen: Germanium, Silizium.

Zwischen der epitaktischen Halbleiterschichtenfolge und dem Träger ist besonders bevorzugt eine reflektierende Schicht angeordnet, die im Betrieb des Halbleiterkörpers, zumindest die in seiner aktiven Zone erzeugte oder detektierte elektromagnetische Strahlung reflektiert. Bei der reflektierenden Schicht kann es sich beispielsweise um einen Bragg-Reflektor handeln.

Der Träger kann beispielsweise mit einer Lotschicht oder einer Klebstoffschicht stoffschlüssig mit der epitaktischen Halbleiterschichtenfolge verbunden sein. Besonders bevorzugt ist die Lotschicht oder die Klebstoffschicht hierbei elektrisch leitend ausgebildet, so dass der Dünnfilm-Halbleiterkörper später über seine Rückseite elektrisch leitend kontaktiert werden kann. Die Rückseite des Halbleiterkörpers liegt hierbei seiner Strahlungsdurchtrittsfläche gegenüber.

Ein geeignetes Lot enthält bevorzugt eines der folgenden Materialien oder ist aus einem der Materialien beziehungsweise einer Legierung dieser Materialien gebildet: Titan, Platin, Gold, Zinn.

Gemäß einer Ausführungsform ist zwischen der Lotschicht und dem Träger eine Barriereschicht angeordnet, die dazu dient, eine Diffusion der darunterliegenden Materialien in die aktive Zone zumindest zu verringern.

Die Barriereschicht kann beispielsweise aus Einzelschichten aufgebaut sein. Die Einzelschichten können beispielsweise eines der folgenden Materialien aufweisen oder aus einem der folgenden Materialien bestehen: Platin, Gold-Zinn, Titanwolframnitrid.

Gemäß einer weiteren Ausführungsform ist auf der Rückseite des Halbleiterkörpers eine Metallisierung aufgebracht, die dazu dient, den Halbleiterkörper elektrisch zu kontaktieren. Die Metallisierung kann aus Einzelschichten aufgebaut sein. Die Einzelschichten der Metallisierung weisen beispielsweise eines der folgenden Materialien auf oder bestehen aus einem der folgenden Materialien: Platin, Gold, Titan.

Weitere vorteilhafte Ausführungsformen und Weiterbildungen der Erfindung ergeben sich aus den im Folgenden in Verbindung mit den Figuren beschriebenen Ausführungsbeispielen.
- Figur 1: zeigt eine schematische Draufsicht auf einen Halbleiterwafer gemäß einem ersten Ausführungsbeispiel.
- Figuren 2A bis 2C: zeigen schematische Schnittdarstellungen eines Halbleiterwafers während verschiedener Verfahrensstadien gemäß einem ersten Ausführungsbeispiel.
- Figur 3: zeigt eine schematische Schnittdarstellung eines Halbleiterwafers während einem Verfahrensstadium gemäß einem Beispiel.
- Figur 4: zeigt eine schematische Schnittdarstellung eines Halbleiterwafers während einem Verfahrensstadium gemäß einem weiteren Beispiel.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente, insbesondere Schichtdicken zur besseren Darstellbarkeit und/oder zum besseren Verständnis übertrieben groß dargestellt sein.

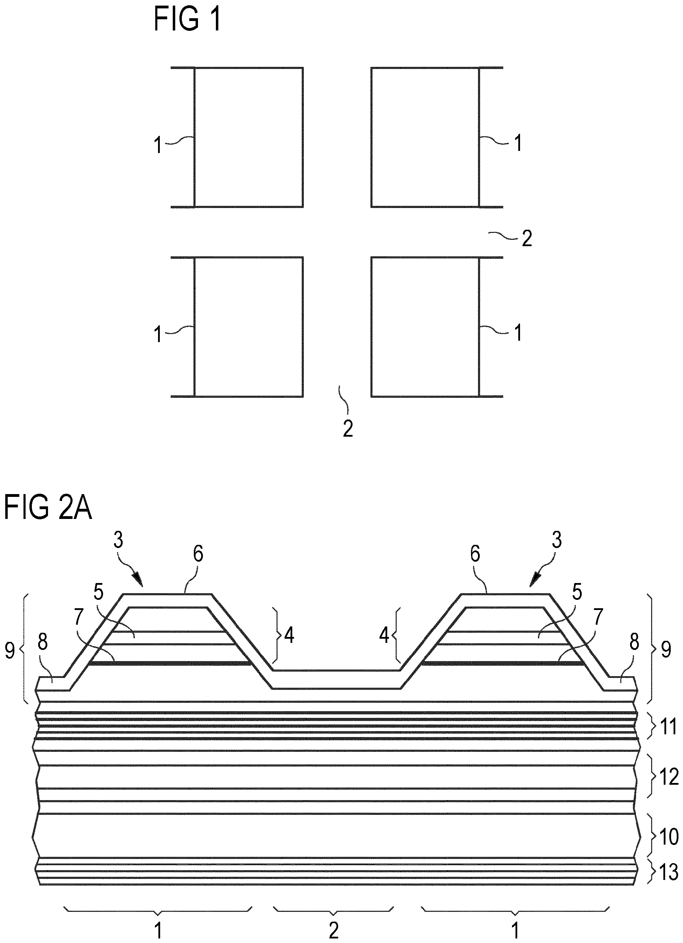

Der Halbleiterwafer gemäß dem Ausführungsbeispiel der Figur 1 weist eine Vielzahl an Chipbereichen 1 auf, zwischen denen linienförmige Trennbereiche 2 in Form eines Rasters angeordnet sind. Bei den Trennbereichen 2 kann es sich beispielsweise um Sägegräben handeln.

Jeder Chipbereich 1 umfasst einen Halbleiterkörper 3, beispielsweise einen Leuchtdioden-Halbleiterkörper in Dünnfilmbauweise. Die Chipbereiche 1 sind dazu vorgesehen, entlang der Trennbereiche 2 in separate Halbleiterkörper 3 vereinzelt zu werden, beispielsweise mittels eines Lasertrennprozesses.

Der Halbleiterwafer gemäß dem Ausführungsbeispiel der Figur 2A weist mehrere Chipbereiche 1 auf. In Figur 2A sind aus Gründen der Übersichtlichkeit lediglich zwei benachbarte Chipbereiche 1 dargestellt, zwischen denen ein Trennbereich 2 angeordnet ist. Jeder Chipbereich 1 weist einen Dünnfilm-Halbleiterkörper 3 auf, der zur Strahlungserzeugung vorgesehen ist.

Jeder Dünnfilm-Halbleiterkörper 3 weist eine epitaktische Halbleiterschichtenfolge 4 auf, die eine aktive Zone 5 zur Strahlungserzeugung umfasst. Auf der von der Strahlungsdurchtrittsfläche 6 abgewandten Seite der Halbleiterschichtenfolge 4 ist eine reflektierende Schicht 7 angeordnet, die dazu vorgesehen ist, die im Betrieb des Halbleiterkörpers 3 in der aktiven Zone 5 erzeugte Strahlung zur Strahlungsdurchtrittsfläche 6 hin zu reflektieren.

Auf die Strahlungsdurchtrittsfläche 6 des Halbleiterkörpers 3 ist eine transmittierende Schicht 8 aufgebracht. Die transmittierende Schicht 8 ist vorliegend durchgehend auf der gesamten Oberfläche des Halbleiterwafers angeordnet. Insbesondere sind die Seitenflächen 9 der Chipbereiche 1 vollständig mit der transmittierenden Schicht 8 bedeckt.

Bei der transmittierenden Schicht 8 kann es sich beispielsweise um eine Passivierungsschicht handeln, die etwa ein Oxid oder ein Nitrid aufweist oder aus einem Oxid oder Nitrid gebildet ist. Die transmittierende Schicht 8 ist insbesondere dazu vorgesehen, die aktive Zone 5 vor äußeren chemischen Einflüssen zu schützen und Kurzschlüsse der aktiven Zone 5 zu vermeiden.

Auf die der Strahlungsdurchtrittsfläche 6 gegenüberliegende Seite der Halbleiterschichtenfolge 4 ist ein Träger 10 angeordnet, der dazu vorgesehen ist, die Halbleiterschichtenfolge 4 mechanisch zu stabilisieren. Der Träger 10 kann beispielsweise aus Germanium gebildet sein.

Zwischen der Halbleiterschichtenfolge 4 und dem Träger 10 ist vorliegend eine Lotschicht 11 angeordnet, die den Träger 10 mit der Halbleiterschichtenfolge 4 stoffschlüssig verbindet. Die Lotschicht 11 kann beispielsweise eines der folgenden Materialien enthalten oder aus einem dieser Materialien oder einer Legierung dieser Materialien gebildet sein: Gold, Zinn.

Zwischen der Lotschicht 11 und dem Träger 10 ist weiterhin eine Barriereschicht 12 angeordnet, die aus Einzelschichten aufgebaut ist. Die Einzelschichten können beispielsweise eines der folgenden Materialien aufweisen oder aus einem der folgenden Materialien gebildet sein: Platin, Gold-Zink, Titan, Titanwolframnitrid.

Auf der von der Halbleiterschichtenfolge 4 abgewandten Hauptseite des Trägers 10 ist weiterhin eine Metallisierung 13 aufgebracht, die dazu vorgesehen ist, den Halbleiterkörper 3 rückseitig elektrisch zu kontaktieren. Die Metallisierung 13 kann ebenfalls aus Einzelschichten aufgebaut sein, die eines der folgenden Materialien aufweisen oder aus einem der folgenden Materialien gebildet sind: Platin, Gold, Titan.

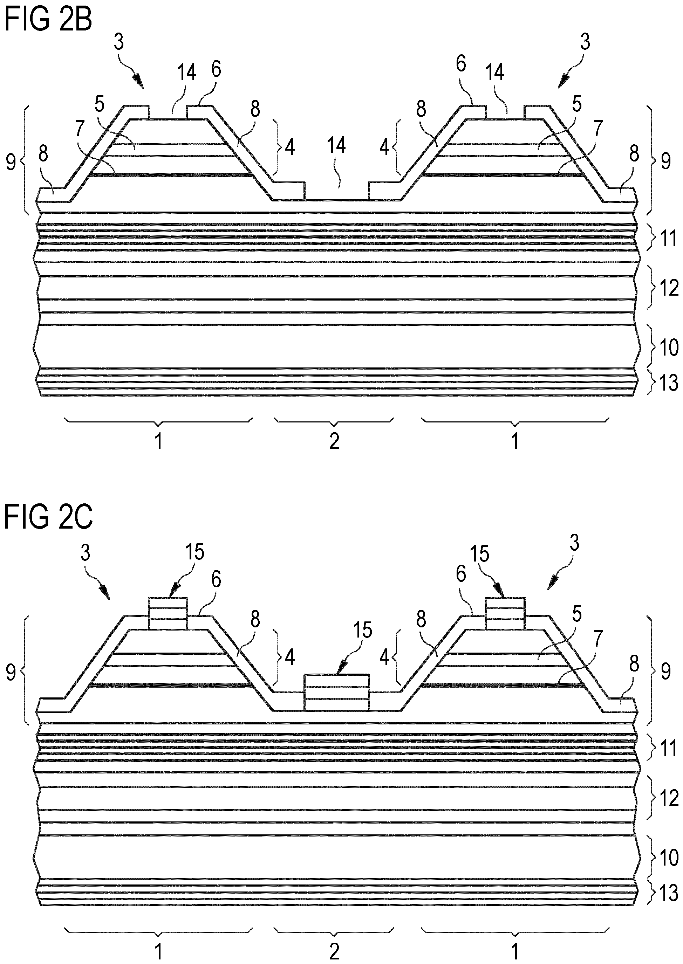

In einem nächsten Schritt wird jeweils innerhalb eines Chipbereiches 1 eine Öffnung 14 in der transmittierenden Schicht 8 erzeugt (Figur 2B). Gleichzeitig wird auch in dem Trennbereich 2 eine Öffnung 14 in der transmittierenden Schicht 8 erzeugt. Die Öffnungen 14 durchdringen die transmittierende Schicht 8 vorliegend jeweils vollständig. Zur lokalen Erzeugung der Öffnungen 14 innerhalb der dafür vorgesehenen Bereiche wird beispielsweise vor dem Entfernen der transmittierenden Schicht 8 eine Fotostrukturierung der Oberfläche vorgenommen. Bei dem vorliegenden Ausführungsbeispiel ist es vorteilhafterweise möglich, die Öffnungen 14 innerhalb der transmittierenden Schicht 8 mit lediglich einer einzigen Fotostrukturierung zu erzeugen.

In einem nächsten Schritt (Figur 2C) wird innerhalb der Öffnungen 14 eine metallische Schicht 15 abgeschieden. Die metallische Schicht 15 ist vorliegend aus drei Einzelschichten aufgebaut. Die Einzelschichten weisen hierbei beispielsweise eines der folgenden Materialien auf oder bestehen aus einem der folgenden Materialien: Titan, Platin, Gold.

Die metallische Schicht 15 innerhalb der Öffnungen 14 in den Chipbereichen 1 ist zur späteren elektrischen Kontaktierung des Halbleiterkörpers 3 vorgesehen. Innerhalb der Öffnungen 14 des Trennbereichs 2 ist die metallische Schicht 15 dazu vorgesehen, die Laserstrahlung bei einem späteren Lasertrennprozess zu absorbieren, so dass eine bessere Trennung erfolgt.

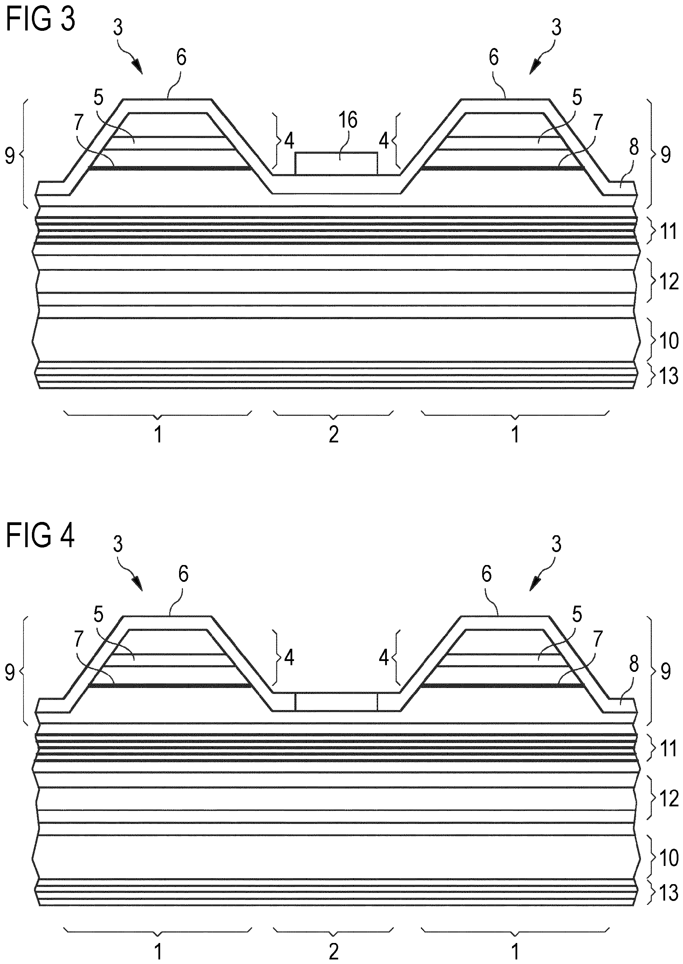

Bei dem Beispiel gemäß Figur 3 werden im Unterschied zu dem Ausführungsbeispiel gemäß der Figuren 2A bis 2C keine Öffnungen 14 in der transmittierenden Schicht 8 erzeugt. Vielmehr wird ausgehend von einem Halbleiterwafer, wie er anhand Figur 2A bereits beschrieben ist, eine absorbierende Schicht 16 lokal innerhalb des Trennbereiches 2 aufgebracht. Die absorbierende Schicht 16 wird hierbei bevorzugt nur innerhalb des Trennbereiches 2 angeordnet, während die Chipbereiche 1 frei bleiben von der absorbierenden Schicht 16. Die absorbierende Schicht 16 ist vorliegend in direktem Kontakt mit der transmittierenden Schicht 8 angeordnet und weist bevorzugt eines der folgenden Materialien auf: Platin, Ruthenium, Rhodium, Osmium, Iridium, Zirkonium, Vanadium, Tantal, Chrom, Molybdän, Wolfram, Carbide, Wolframcarbid, Titancarbid, Siliziumcarbid, Silizium, Nitride, Titannitrid, Tantalnitrid. Die absorbierende Schicht 16 weist eine Schmelz- und/oder Siedetemperatur auf, die höher ist als die Schmelz- und/oder Siedetemperatur der transmittierenden Schicht 8.

Im Unterschied zu den Ausführungsbeispielen der Figuren 2A bis 2C und 3 wird bei dem Beispiel gemäß der Figur 4 ausgehend von einem Halbleiterwafer, wie er anhand von Figur 2A bereits beschrieben ist, die transmittierende Schicht 8 selber innerhalb des Trennbereiches 2 modifiziert. Die Modifizierung findet hierbei derart statt, dass der Absorptionskoeffizient lokal innerhalb des Trennbereiches 2 erhöht ist. Eine solche Modifizierung kann beispielsweise durch Einbringen von Streuzentren, Implantation von Fremdstoffen beziehungsweise nasschemische Reaktionen erfolgen.

Die vorliegende Anmeldung beansprucht die Priorität der deutschen Anmeldung DE 10 2011 017 097.9.

Die Erfindung ist nicht durch die Beschreibung anhand der Ausführungsbeispiele auf diese beschränkt. Die Erfindung ist ausschließlich durch die Ansprüche definiert.

## Patentansprüche

1. Verfahren zur Herstellung eines Halbleiterkörpers (3) mit den Schritten:
- Bereitstellen eines Halbleiterwafers mit mindestens zwei Chipbereichen (1) und mindestens einem Trennbereich (2), der zwischen den Chipbereichen (1) angeordnet ist, wobei der Halbleiterwafer eine Schichtenfolge aufweist, deren äußerste Schicht zumindest innerhalb des Trennbereiches (2) eine transmittierende Schicht (8) aufweist, die für elektromagnetische Strahlung durchlässig ist,
- Entfernen der transmittierenden Schicht (8) innerhalb des Trennbereichs (2), und
- Trennen der Chipbereiche (1) entlang der Trennbereiche (2) mittels eines Lasers,
**dadurch gekennzeichnet, dass**
- die transmittierende Schicht (8) bei dem Schritt des Entfernens der transmittierenden Schicht (8) innerhalb des Trennbereichs (2) mit einem Ätzprozess entfernt wird.

2. Verfahren nach dem vorherigen Anspruch,
bei dem
- die Schichtenfolge innerhalb der Chipbereiche (1) eine aktive Zone (5) aufweist, die zur Erzeugung elektromagnetischer Strahlung geeignet ist, und
- der Trennbereich (2) die aktive Zone (5) vollständig durchdringt.

3. Verfahren nach einem der obigen Ansprüche,
bei dem die transmittierende Schicht (8) eine Passivierungsschicht ist.

4. Verfahren nach einem der obigen Ansprüche,
bei dem die transmittierende Schicht (8) eines der folgenden Materialien aufweist: Oxide, Nitride.

5. Verfahren nach einem der obigen Ansprüche,
bei dem die Dicke der transmittierenden Schicht (8) zwischen einschließlich 3 nm und einschließlich 500 nm liegt.

6. Verfahren nach einem der obigen Ansprüche,
bei dem die transmittierende Schicht (8) die Seitenflächen (9) der Chipbereiche (1) vollständig bedeckt.

7. Verfahren nach einem der obigen Ansprüche,
bei dem
- die transmittierende Schicht (8) in dem Trennbereich (2) und in den Chipbereichen (1) lokal entfernt wird, so dass jeweils zumindest eine Öffnung (14) in der transmittierenden Schicht (8) innerhalb des Trennbereichs (2) und innerhalb der Chipbereiche (1) entsteht und
- vor dem Trennen der Chipbereiche (1) eine metallische Schicht (15) in den Öffnungen (14) der transmittierenden Schicht (8) angeordnet wird.

8. Verfahren nach dem vorherigen Anspruch,
bei dem die metallische Schicht (15) in den Öffnungen (14) der Chipbereiche (1) als elektrischer Kontakt des jeweiligen Halbleiterkörpers (3) vorgesehen ist.

9. Verfahren nach einem der obigen Ansprüche,
bei dem die absorbierende Schicht (16) auf der transmittierenden Schicht (8) eines der folgenden Materialien aufweist: Platin, Ruthenium, Rhodium, Osmium, Iridium, Zirkonium, Vanadium, Tantal, Chrom, Molybdän, Wolfram, Carbide, Wolframcarbid, Titancarbid, Siliziumcarbid, Silizium, Nitride, Titannitrid, Tantalnitrid.

10. Verfahren nach einem der obigen Ansprüche,
bei dem jeder Chipbereich (1) einen optoelektronischen Dünnfilm-Halbleiterkörper (3) aufweist.

11. Verfahren nach einem der obigen Ansprüche,
bei dem der Trennbereich (2) ein Sägegraben ist.

## Claims

1. A method for producing a semiconductor body (3) comprising the following steps:
- providing a semiconductor wafer having at least two chip regions (1) and at least one separating region (2), which is arranged between the chip regions (1), wherein the semiconductor wafer comprises a layer sequence, the outermost layer of which has, at least within the separating region (2) a transmissive layer (8) that is transmissive to electromagnetic radiation,
- removing the transmissive layer (8) within the separating region (2), and
- separating the chip regions (1) along the separating regions (2) by means of a laser.
**characterized in that**
- the transmissive layer (8) is removed within the separating region (2) by means of an etching process during the removal of the transmissive layer (8)

2. The method according to the preceding claim,
wherein
- the layer sequence has, within the chip regions (1), an active zone (5), which is suitable for generating electromagnetic radiation, and
- the separating region (2) completely penetrates through the active zone (5).

3. The method according to any of the preceding claims, wherein the transmissive layer (8) is a passivation layer.

4. The method according to any of the preceding claims, wherein the transmissive layer (8) comprises one of the following materials: oxides, nitrides.

5. The method according to any of the preceding claims, wherein the thickness of the transmissive layer (8) is between 3 nm and 500 nm, inclusive.

6. The method according to any of the preceding claims, wherein the transmissive layer (8) completely covers the side faces (9) of the chip regions (1).

7. The method according to any of the preceding claims, wherein
- the transmissive layer (8) is locally removed in the separating region (2) and in the chip regions (1), such that in each case at least one opening (14) arises in the transmissive layer (8) within the separating region (2) and within the chip regions (1) and
- prior to separating the chip regions (1), a metallic layer (15) is arranged in the openings (14) of the transmissive layer (8).

8. The method according to the preceding claim,
wherein the metallic layer (15) in the openings (14) of the chip regions (1) is provided as an electrical contact of the respective semiconductor body (3).

9. The method according to any of the preceding claims, wherein the absorbent layer (16) on the transmissive layer (8) comprises one of the following materials: platinum, ruthenium, rhodium, osmium, iridium, zirconium, vanadium, tantalum, chromium, molybdenum, tungsten, carbides, tungsten carbide, titanium carbide, silicon carbide, silicon, nitrides, titanium nitride, tantalum nitride.

10. The method according to any of the preceding claims, wherein each chip region (1) has an optoelectronic thin-film semiconductor body (3).

11. The method according to any of the preceding claims, wherein the separating region (2) is a sawing trench.

## Revendications

1. Procédé de fabrication d'un corps semi-conducteur (3) comprenant les étapes suivantes :
mise à disposition d'une tranche de semi-conducteur comprenant au moins deux zones à puces (1) et au moins une zone de séparation (2) disposée entre les zones à puces (1), la tranche de semi-conducteur comportant une séquence de couches dont la couche la plus externe présente, au moins à l'intérieur de la zone de séparation (2), une couche transmettrice (8) perméable au rayonnement électromagnétique,
- élimination de la couche transmettrice (8) à l'intérieur de la zone de séparation (2) et
- séparation des zones à puces (1) le long des zones de séparation (2) au moyen d'un laser,
**caractérisé en ce que**
- lors de l'étape de séparation de la couche transmettrice (8) au sein de la zone de séparation (2), la couche transmettrice (8) est éliminée à l'aide d'un processus de gravure.

2. Procédé selon la revendication précédente,
dans lequel
- la séquence de couches à l'intérieur des zones à puces (1) présente une zone active (5) apte à générer un rayonnement électromagnétique, et
- la zone de séparation (2) passe complètement à travers la zone active (5).

3. Procédé selon l'une des revendications précédentes, dans lequel la couche transmettrice (8) est une couche de passivation.

4. Procédé selon l'une des revendications précédentes, dans lequel la couche transmettrice (8) comporte une des matières suivantes : oxydes, nitrures.

5. Procédé selon l'une des revendications précédentes, dans lequel l'épaisseur de la couche transmettrice (8) est comprise entre 3 nm et 500 nm.

6. Procédé selon l'une des revendications précédentes,
dans lequel la couche transmettrice (8) recouvre entièrement les faces latérales (9) des zones à puces (1).

7. Procédé selon l'une des revendications précédentes,
dans lequel
- la couche transmettrice (8) est enlevée localement dans la zone de séparation (2) et dans les zones à puces (1), de manière à créer au moins une ouverture (14) chacune dans la couche transmettrice (8) à l'intérieur de la zone de séparation (2) et à l'intérieur des zones à puces et
- avant la séparation des zones à puces (1), une couche métallique (15) est disposée dans les ouvertures (14) de la couche transmettrice (8).

8. Procédé selon la revendication précédente,
dans lequel la couche métallique (15) est prévue dans les ouvertures (14) des zones à puces (1) sous forme de contact électrique du corps semi-conducteur respectif (3).

9. Procédé selon l'une des revendications précédentes, dans lequel la couche absorbante (16) comprend sur la couche transmettrice (8) l'un des matériaux suivants : platine, ruthénium, rhodium, osmium, iridium, zirconium, vanadium, tantale, chrome, molybdène, tungstène, carbures, carbure de tungstène, carbure de titane, carbure de silicium, silicium, nitrures, nitrure de titane, nitrure de tantale.

10. Procédé selon l'une des revendications précédentes, dans lequel chaque zone à puces (1) présente un corps semi-conducteur optoélectronique à couche mince (3).

11. Procédé selon l'une des revendications précédentes, dans lequel la zone de séparation (2) est une tranchée de sciage.
